# EUROPEAN PATENT APPLICATION

(11) **EP 4 826 315 A1**
(43) Date of publication of application: **21.10.2026**
(21) Application number: 24918977.0
(22) Date of filing: 06.12.2024
(51) Int. Cl.: F25D 15/00, F25D 19/00, F25B 21/02, H10N 10/17, H10N 10/82, H10N 19/00

(54) **REFRIGERATOR INCLUDING THERMOELECTRIC MODULE**

(30) Priority: 15.01.2024 KR 20240005917
(71) Applicant: Samsung Electronics Co., Ltd., Suwon-si, Gyeonggi-do 16677 (KR)
(72) Inventor: KWON, Dusu, Suwon-si Gyeonggi-do 16677 (KR); GIM, Sangyun, Suwon-si Gyeonggi-do 16677 (KR); KIM, Youngryol, Suwon-si Gyeonggi-do 16677 (KR); LEE, Jaesoo, Suwon-si Gyeonggi-do 16677 (KR)
(74) Representative: Walaski, Jan Filip
(86) International application number: PCT/KR2024/019903
(87) International publication number: WO 2025/154952

(57) **Abstract**

A refrigerator according to embodiments of the present disclosure may comprise: a storage compartment; a main body including the storage compartment; and a cold air supply device for supplying cold air to the storage compartment. The cold air supply device may comprise at least one of a thermoelectric module, a cooling sink, and a heat dissipation sink. The thermoelectric module comprises: a lower substrate; a lower conductive pattern layer formed on the lower substrate; a thermoelectric element layer formed on the lower conductive pattern layer; an upper conductive pattern layer formed on the thermoelectric element layer; an upper substrate formed on the upper conductive pattern layer; and at least one SMD connector electrically connected to the lower conductive pattern layer.

## Description

### Technical Field

Various embodiments of the disclosure relate to a refrigerator including a thermoelectric module.

### Background Art

A refrigerator is a home appliance that cools food in a storage compartment or stores food at low temperatures to prevent food spoilage or deterioration and to keep food fresh. The storage compartment includes a refrigerating compartment maintained at about 0 to 5 degrees Celsius for refrigerated storage of food, and a freezing compartment maintained at about 0 to minus 30 degrees Celsius for frozen storage of food. A door is provided on the front of the main body to open and close the storage compartment. The door is rotatably provided on the front of the main body to open and close the storage compartment. Further, the door may be provided as a drawer-type door to open and close the storage compartment.

Meanwhile, the refrigerator may include a storage compartment capable of receiving food and a cold air supply device for cooling the storage compartment. The refrigerator may use the cold air supply device to freeze/refrigerate the storage compartment to keep food stored in the storage compartment fresh for a long period. Generally, cold air supply devices may be classified into a refrigerating cycle device using a refrigerating cycle and a Peltier cooling device using a Peltier element according to a method of generating cold air.

For example, a refrigerating cycle device may obtain cold air by circulating refrigerant along a closed circuit composed of a compressor, a condenser, an expander, and an evaporator.

For example, a Peltier cooling device may obtain cold air using a thermoelectric module that generates a Peltier effect. Here, the Peltier effect may refer to a phenomenon in which in case that a potential difference is applied to two opposite sides of an object, heat flows along with current, causing one side to be heated and the other side to be cooled.

### Disclosure of Invention

### Solution to Problems

Various embodiments of the disclosure may provide a refrigerator including a thermoelectric module having an SMD connector mounted thereon and receiving power from an external source through a wire, and a thermoelectric module for a refrigerator having an SMD connector mounted thereon and receiving power from an external source through a wire.

A refrigerator according to embodiments of the disclosure may include a storage compartment, a main body including the storage compartment, and a cold air supply device supplying cold air to the storage compartment. The cold air supply device may include a thermoelectric module. The thermoelectric module may include a lower substrate, a lower conductive pattern layer formed on the lower substrate, a thermoelectric element layer formed on the lower conductive pattern layer, an upper conductive pattern layer formed on the thermoelectric element layer, an upper substrate formed on the upper conductive pattern layer, and at least one surface mount device (SMD) connector electrically connected to the lower conductive pattern layer.

A method for manufacturing a thermoelectric module for a refrigerator according to embodiments of the disclosure may include an operation of forming a lower conductive pattern layer on a lower substrate, an operation of forming an upper conductive pattern layer on an upper substrate, an operation of forming a thermoelectric element layer on the lower conductive pattern layer, an operation of performing a reflow process on the lower substrate, the thermoelectric element layer, and the upper substrate, and an operation of soldering at least one surface mount device (SMD) connector to the lower conductive pattern layer.

Various embodiments of the disclosure may provide a refrigerator including a thermoelectric module having an SMD connector mounted thereon and receiving power from an external source through a wire, and a thermoelectric module for a refrigerator having an SMD connector mounted thereon and receiving power from an external source through a wire.

According to various embodiments of the disclosure, the refrigerator including the thermoelectric module and the method for manufacturing a thermoelectric module for a refrigerator of the disclosure may include a thermoelectric module having an SMD connector mounted thereon and receiving power from an external source through a wire.

Accordingly, the refrigerator including the thermoelectric module and the method for manufacturing a thermoelectric module for a refrigerator of the disclosure do not require performing a separate process of soldering a power supply wire after the manufacturing process of the thermoelectric module, and thus the manufacturing process of the thermoelectric module may be simplified and the manufacturing cost may be decreased.

Further, the refrigerator including the thermoelectric module and the method for manufacturing a thermoelectric module for a refrigerator of the disclosure may increase heat transfer efficiency and enhance the performance of the thermoelectric module due to precise electrical connection between the conductive pattern layer and the SMD connector of the thermoelectric module.

Further, the refrigerator including the thermoelectric module and the method for manufacturing a thermoelectric module for a refrigerator of the disclosure may lower the disposal rate of the thermoelectric module and increase the lifespan of the thermoelectric module since maintenance, repair, and replacement of the thermoelectric module are facilitated as the SMD connector is mounted on the thermoelectric module.

The effects obtainable from the exemplary embodiments of the disclosure are not limited to the effects mentioned above, and other effects not mentioned may be clearly derived and understood by a person skilled in the art to which the exemplary embodiments of the disclosure belong from the following description. In other words, unintended effects in practicing embodiments of the disclosure may also be derived by one of ordinary skill in the art from example embodiments of the disclosure.

### Brief Description of Drawings

FIG. 1 illustrates a schematic internal and external appearance of a refrigerator according to an embodiment of the disclosure.
FIG. 2 schematically illustrates a block configuration of a refrigerator from the perspective of function and control according to an embodiment of the disclosure.
FIG. 3 illustrates a configuration of a cold air supply device according to an embodiment of the disclosure.
FIG. 4 illustrates a cross-section of a thermoelectric module according to an embodiment of the disclosure.
FIG. 5 illustrates thermoelectric cooling by the Peltier effect of a thermoelectric module according to an embodiment of the disclosure.
FIG. 6 illustrates thermoelectric power generation by the Seebeck effect of a thermoelectric module according to an embodiment of the disclosure.
FIG. 7 illustrates a perspective view illustrating a thermoelectric module according to an embodiment of the disclosure.
FIG. 8 illustrates a plan view illustrating a thermoelectric module according to an embodiment of the disclosure.
FIG. 9A illustrates a perspective view illustrating an SMD connector according to an embodiment of the disclosure.
FIG. 9B illustrates a plan view illustrating an SMD connector according to an embodiment of the disclosure.
FIG. 10 illustrates a perspective view illustrating a thermoelectric module according to an embodiment of the disclosure.
FIG. 11 illustrates a plan view illustrating a thermoelectric module according to an embodiment of the disclosure.
FIG. 12A illustrates a perspective view illustrating an SMD connector according to an embodiment of the disclosure.
FIG. 12B illustrates a plan view illustrating an SMD connector according to an embodiment of the disclosure.
FIG. 13 illustrates a method for manufacturing a thermoelectric module for a refrigerator according to an embodiment of the disclosure.

### Mode for the Invention

Terms used in this document are used only to describe specific embodiments and are not intended to limit the technical features of this document. For example, a component represented in the singular should be understood as a concept including a singular or plural component unless the context clearly indicates only the singular.

As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. The term "and/or" used in this document should be understood to encompass any and all possible combinations by one or more of the plurality of items listed along with the corresponding term. Terms such as "first " or "second" used in this document may be simply used to distinguish the corresponding component from another component and do not limit the corresponding components in other aspects (e.g., importance or order).

In case that a (e.g., first) component is referred to as being "coupled," "connected," "linked," "combined," "supported," "connected to," or "in contact with" another (e.g., second) component, with or without the term "functionally" or "communicatively," it includes not only a case in which the component is directly coupled, connected, linked, combined, supported, or in contact with the other component but also a case in which the component is indirectly coupled, connected, linked, combined, supported, or in contact with the other component through a third component.

It will be further understood that the terms "comprise" and/or "have," as used herein, specify the presence of stated features, integers, steps, operations, elements, and/or components, but do not preclude the presence or addition of one or more other features, integers, steps, operations, elements, components, and/or groups thereof. Throughout the specification, in case that one component is positioned "on" another component, the first component may be positioned directly on the second component, or other component(s) may be positioned between the first and second component.

As used herein, the terms "configured to" may be interchangeably used with the terms "suitable for," "having the capacity to," "designed to," "adapted to," "made to," or "capable of' depending on circumstances. The term "configured to" may not necessarily mean only "specifically designed in hardware." Rather, the term "configured to" may mean that a device can perform an operation together with another device or parts. For example, a 'device configured (or set) to perform A, B, and C' may be a dedicated device to perform the corresponding operation or may mean a general-purpose device capable of various operations including the corresponding operation.

The terms "upper side", "lower side", and "front and rear directions" used in the disclosure are defined with respect to the drawings, and the shape and position of each component are not limited by these terms.

In the disclosure, the above-described description has been made mainly of specific embodiments, but the disclosure is not limited to such specific embodiments, but should rather be appreciated as covering all various modifications, equivalents, and/or substitutes of various embodiments. In connection to the description of the drawings, similar reference numerals may be used for similar or related components.

Refrigerators according to various examples of the disclosure may be classified according to the shape of the storage compartment and the door. For example, refrigerators may include top mounted freezer (TMF) refrigerators in which storage compartments are partitioned vertically by a horizontal partition wall so that a freezing compartment is formed on the upper side, and a refrigerating compartment is formed on the lower side, bottom mounted freezer (BMF) refrigerators in which a refrigerating compartment is formed on the upper side, and a freezing compartment is formed on the lower side, side by side (SBS) refrigerators in which storage compartments are partitioned left and right by a vertical partition wall so that a freezing compartment is formed on one side, and a refrigerating compartment is formed on the other side, and French door refrigerator (FDR) refrigerators in which storage compartments are partitioned vertically by a horizontal partition wall, so that a refrigerating compartment is formed on the upper side and opened/closed by a pair of doors, and a freezing compartment is formed on the lower side.

Hereinafter, various exemplary refrigerators are described in detail with reference to the drawings.

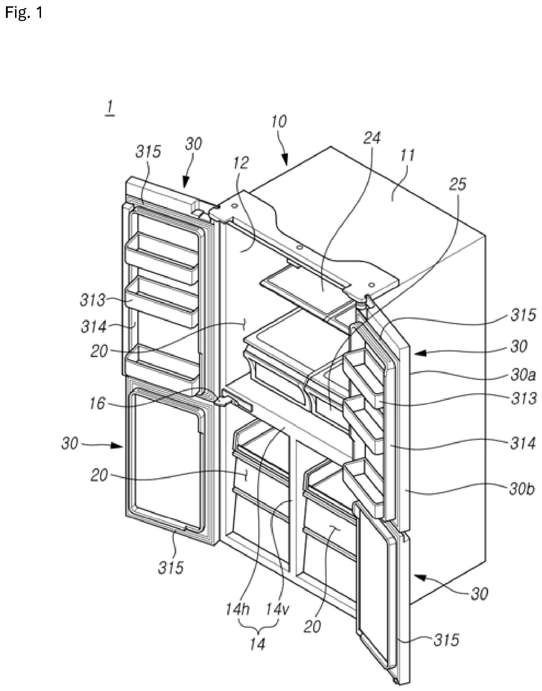

FIG. 1 illustrates a schematic internal and external appearance of a refrigerator 1 according to an embodiment.

The refrigerator 1 may include a main body 10. The main body 10 may include an outer case 11 and an inner case 12 disposed inside the outer case 11. The outer case 11 may be provided to form at least a portion of the outer appearance of the main body 10. In an example, the outer case 11 may be configured to include a metal material having excellent durability and aesthetics. The inner case 12 may be provided to define a space of the storage compartment 20. The inner case 12 may include a case, a plate, a panel, and/or a liner forming the storage compartment 20. The inner case 12 may be formed as a single body or may be formed by assembling a plurality of plates. In an example, the inner case 12 may be integrally injection-molded using a plastic material, but the disclosure is not limited thereto.

Although not illustrated, an accommodation space may be formed between the outer case 11 and the inner case 12. An insulation material (not shown) for insulating the storage compartment 20 may be provided in at least a portion of the accommodation space. The insulation material may insulate between the inside of the storage compartment 20 and the outside of the storage compartment 20 so that the temperature inside the storage compartment 20 may be maintained at a set appropriate temperature without being affected by the external environment outside the storage compartment 20.

According to an example, the insulation material may include a foam insulation material. In an example, after fixing the inner case 12 and the outer case 11 with a jig or the like, the foam insulation material may be formed by injecting and foaming a urethane foam mixed with polyurethane and a foaming agent into an accommodation space between the inner case 12 and the outer case 11. According to an embodiment, the insulation material may include a vacuum insulation material in addition to the foam insulation material or in place of the foam insulation material. The vacuum insulation material may include a core material and an outer cover material that accommodates the core material and seals the inside at a pressure close to vacuum or vacuum. The vacuum insulation material may further include an adsorbent adsorbing gas and moisture to stably maintain the vacuum state. The insulation material of the refrigerator 1 is not limited to the above-described foam insulation material or vacuum insulation material and may be configured using various materials usable for insulation.

According to an embodiment, the refrigerator 1 may include a storage compartment 20. The storage compartment 20 may store food. The food includes edible or drinkable food items, and specifically, may include meat, fish, seafood, fruit, vegetables, water, ice, beverages, kimchi, or alcoholic beverages such as wine. In addition to food, medicine or cosmetics may be stored in the storage compartment 20, and there is no limitation on items storable in the storage compartment 20.

According to an example, the refrigerator 1 may include one or more storage compartments 20. When two or more storage compartments 20 are formed in the refrigerator 1, each storage compartment may have a different purpose and may be maintained at a different temperature. To this end, each storage compartment 20 may be partitioned from each other by a partition wall 14 including an insulation material. In an example, the storage compartment may be referred to as a "refrigerating compartment", a "freezing compartment", or a "variable temperature compartment" according to the use and/or the temperature range. For example, the refrigerating compartment may refer to a storage compartment in a case where it is maintained at a temperature appropriate for refrigerating food, and the freezing compartment may refer to a storage compartment in a case where it is maintained at a temperature appropriate for freezing food. Refrigerating may refer to cooling food to the extent that the food is not frozen, and for example, the refrigerating compartment may be maintained in the range of 0 degrees Celsius to 7 degrees Celsius. Freezing may mean freezing food or cooling food to remain frozen, and for example, the freezing compartment may be maintained in the range of minus 20 degrees Celsius to minus 1 degree Celsius. The variable temperature compartment may refer to a storage compartment that may be maintained at a predetermined variable temperature by the user's selection or regardless of the user's selection. According to an embodiment, one storage compartment may be provided so that a portion thereof is used as a refrigerating compartment and the remaining portion thereof is used as a freezing compartment. The storage compartment may be referred to as various names such as "vegetable compartment," "fresh compartment," "cooling compartment," and "ice-making compartment" in addition to the above-mentioned names "refrigerating compartment," "freezing compartment," and "variable temperature compartment."

According to an example, the number, size, and/or shape of the storage compartment 20 may vary depending on the shape or position of the partition wall 14. According to an embodiment, the partition wall 14 may be integrally formed with the main body 10. According to an embodiment, the partition wall 14 may be a separate partition provided separately from the main body 10 and assembled to the main body 10.

According to an example, the storage compartment 20 may be partitioned left and right by a vertical partition wall 14v (a partition wall extending in the vertical direction). The size of the storage compartment 20 partitioned left and right may vary depending on the position of the vertical partition wall 14v. For example, the storage compartment 20 in which the vertical partition wall 14v is provided in the middle and partitioned left and right may be provided in mirror symmetry. According to an embodiment, there may be a plurality of vertical partition walls. In case that there are a plurality of vertical partition walls, the storage compartment may be partitioned into three or more along the left-right direction.

According to an example, the storage compartment 20 may be vertically partitioned by a horizontal partition wall 14h (a partition wall extending in the horizontal direction). The size of the storage compartment 20 divided vertically may vary depending on the position of the horizontal partition wall 14h. According to an embodiment, there may be a plurality of horizontal partition walls. In case that there are a plurality of horizontal partition walls, the storage compartment may be divided into three or more storage compartments in the vertical direction.

The refrigerator may be configured to include a plurality of storage compartments having various sizes and shapes according to various combinations of the vertical partition wall and the horizontal partition wall.

According to an example, a plurality of shelves 24 and/or a plurality of storage containers 25 may be provided inside the storage compartment 20. Each of the plurality of shelves 24 and the plurality of storage containers 25 may be separable from an inner space of the storage compartment 20.

According to an example, each storage compartment 20 may be formed so that at least one side thereof is open for loading and unloading food. According to an embodiment, the refrigerator 1 may include each door 30 for opening and closing each storage compartment 20. In an example, the door 30 may be disposed on the front surface of the main body 10 and the storage compartment 20 to open and close the storage compartment 20. The door 30 may be configured to seal the storage compartment 20 while the door is closed. The door 30 may include an insulation material, similar to the main body 10, to insulate the storage compartment 20 from the external environment while the door 30 is closed.

According to an example, the door 30 may be configured to be opened and closed by rotating about the hinge 16, but the disclosure is not limited thereto. In an example, the door may be configured to be opened and closed in a sliding manner.

According to an example, the door 30 may include a door panel 30a and/or a door body 30b. The door panel 30a and the door body 30b may be detachably coupled to each other. For example, one side of the door body 30b may be fixed to the main body 10 by the hinge 16. The door panel 30a may form a part of the front external appearance of the refrigerator 1. Therefore, the door panel 30a may occupy an important element of aesthetics in case that the refrigerator 1 is placed indoors. The door panel 30a may be configured to have various colors and/or various designs and to be replaceable, so that a user may decorate the front external appearance of the refrigerator 1 according to preference. According to an embodiment, the door panel 30a and the door body 30b may be integrally formed with each other.

According to an example, the door 30 may include a door handle (not shown), a door shelf 313, a shelf support 314, and/or a gasket 315. A user may open and close the door 30 using the door handle. The door handle may be recessed in a lower surface or an upper surface of the door 30 or may be formed to protrude at a front surface of the door 30, and is not limited to a specific form.

The door shelf 313 may be provided to receive food. Shelf supports 314 may be provided on both left and right sides of the door shelf 313 to support the door shelf 313. The shelf support 314 may extend vertically from, e.g., the door 30. For example, the shelf support 314 may protrude from the rear surface (the inner surface facing the storage compartment 20) of the door 30 toward the storage compartment 20 and may be provided to extend in the vertical direction. The shelf support 314 may be provided as a separate component separable from the door 30, or may be integrally formed with the door 30.

The gasket 315 may be provided to surround an edge of the door body 30b. The gasket 315 may be provided to seal a gap between the main body 10 and the door 30 in a state in which the door 30 is closed.

According to an example, the refrigerator 1 may include a cold air supply device. The cold air supply device may include a machine, a mechanism, an electronic device, and/or a system combining these capable of generating cold air and guiding the generated cold air to the storage compartment to cool the storage compartment. For example, the cold air supply device may be provided inside the main body 10 to supply cold air to each of the storage compartments 20.

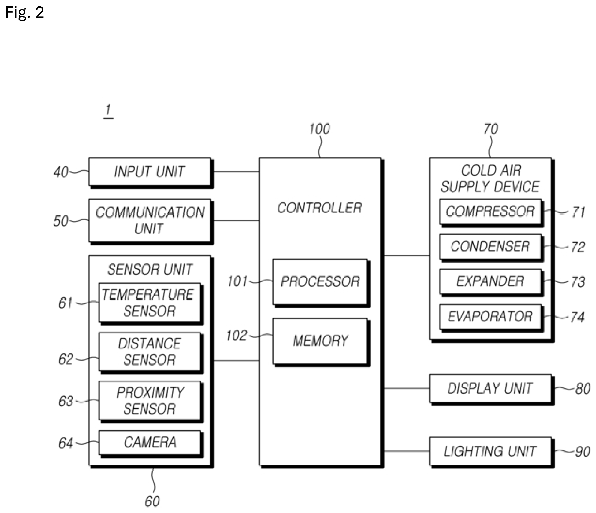

FIG. 2 schematically illustrates a block configuration of the refrigerator 1 from the perspective of function and control according to an embodiment.

According to an example, the refrigerator 1 may include an input unit 40. The input unit 40 may be a component for obtaining a user input for controlling the refrigerator 1.

In an example, the input unit 40 may be installed on a door (e.g., the door 30 of FIG. 1), for the user's convenience. The input unit 40 may include any type of user input means including one or more buttons or switches. Setting data (e.g., a desired storage chamber temperature) by the user may be input via the input unit 40. For example, the input unit 40 may include a touch panel that receives the user's touch input and generates an electrical signal corresponding to the received touch input, but the disclosure is not limited to a specific type of input unit. In an example, the touch panel constituting the input unit 40 may be formed of a transparent material that is positioned on the front surface of a separate display panel provided in the refrigerator 1 and does not distort an image displayed on the display panel. In an example, the input unit 40 may include an infrared signal reception unit. The user may remotely input configuration data via a remote controller, and the input configuration data may be received by the input unit 40 as an infrared signal. In an example, the input unit 40 may include a microphone, and configuration data by the user's voice may be obtained via the microphone.

The configuration data (e.g., a desired temperature of the storage compartment) obtained via the input unit 40 may be transferred to the controller 100 described below. In an example, the configuration data obtained via the input unit 40 may be transmitted to the outside via the communication unit 50 described below, but the disclosure is not limited thereto.

According to an example, the refrigerator 1 may include the communication unit 50 that supports signal transmission/reception to/from the outside. In an example, the communication unit 50 may receive and/or transmit a wired/wireless signal to/from an external wired/wireless communication system, an external server, and/or other devices according to a predetermined wired/wireless communication protocol. In an example, the communication unit 50 may include one or more modules to connect the refrigerator 1 to one or more networks. In an example, the communication unit 50 may include at least one of a mobile communication module, a wired/wireless Internet module, a short-range communication module, and/or a location information module.

In an example, the mobile communication module may transmit/receive wireless signals with at least one of an external base station, an external UE, and an external server via the mobile communication network according to any communication protocol among various communication protocols for mobile communication. The wireless signals may include various types of data signals. In an example, the wireless signals may include voice call signals, video call signals, and text/multimedia message signals, but the disclosure is not limited thereto.

In an example, the wired/wireless internet module may support, e.g., wireless local area network (WLAN), wireless-fidelity (Wi-Fi), Wi-Fi Direct, digital living network alliance (DLNA), wireless broadband (WiBro), world interoperability for microwave access (WiMAX), high speed downlink packet access (HSDPA), high speed uplink packet access (HSUPA), long term evolution (LTE), or long term evolution-advanced (LTE-A), but the disclosure is not limited thereto. In an example, the wired/wireless Internet module of the communication unit 50 may transmit/receive data according to at least one wired/wireless Internet technology among Internet technologies not listed above.

The short-range communication module may be intended for, e.g., short-range communication and may support short-range communication using at least one of Bluetooth, radio frequency identification (RFID), infrared data association (IrDA), ultra-wideband (UWB), ZigBee, near-field communication (NFC), Wi-Fi, Wi-Fi Direct, or wireless universal serial bus (USB) technology. The short-range communication module may support, e.g., wireless communication between the refrigerator 1 and a wireless communication system, between the refrigerator 1 and another device, or between the refrigerator 1 and a network in which the other device is positioned via a short-range wireless communication network.

The location information module may be, e.g., a global positioning system (GPS) module or a Wi-Fi module as a module for obtaining the location of the refrigerator 1. When the refrigerator 1 utilizes the GPS module, the refrigerator 1 may receive information about the location of the refrigerator 1 using the signal transmitted from the GPS satellite. When the refrigerator 1 utilizes the Wi-Fi module, the refrigerator 1 may receive information about the location of the refrigerator 1 based on information about a wireless access point (AP) that transmits and receives a wireless signal to and from the Wi-Fi module.

In an example, the communication unit 50 may receive the configuration data signal input by the user on the mobile terminal of the user in the form of a wireless signal according to a predetermined wireless communication protocol. In an example, the communication unit 50 may receive information and/or a command for controlling the operation of the refrigerator 1 from an external server in the form of a signal according to a predetermined wired/wireless communication protocol. The communication unit 50 may transmit various received signals to the controller 100 described below. In an example, the communication unit 50 may transmit various data generated or obtained on the refrigerator 1 in the form of a wired/wireless signal according to a predetermined wired/wireless communication protocol, e.g., to a mobile terminal of the user or an external server.

According to an example, the refrigerator 1 may include a sensor unit 60. In an example, the sensor unit 60 may include a temperature sensor 61, a distance sensor 62, a proximity sensor 63, and/or a camera 64. However, the types of sensors listed here are merely illustrative and the disclosure is not limited thereto.

In an example, the temperature sensor 61 may include a plurality of temperature sensors provided inside each storage compartment 20 to sense the temperature inside the storage compartment (e.g., the storage compartment 20 of FIG. 1). A plurality of temperature sensors may be installed in each of the plurality of storage compartments 20 to detect the temperature of each of the storage compartments 20. The electrical signal corresponding to the detected temperature may be transferred to the controller 100. Each of the plurality of temperature sensors may include a thermistor whose electrical resistance changes according to temperature. In an example, the temperature sensor 61 may include an external temperature sensor that is provided outside the refrigerator 1 (e.g., at one position of the outer case 11 of FIG. 1) to detect the external temperature around the refrigerator 1.

In an example, the distance sensor 62 may measure the distance to an object, e.g., the user, positioned around the refrigerator 1. The distance sensor 62 may be, e.g., an ultrasonic sensor or an infrared sensor, but is not limited thereto. The distance sensor 62 may detect an object or user around the refrigerator 1 and transfer the detected electrical signal to the controller 100.

In an example, the proximity sensor 63 may be provided to detect opening and closing of the door 30. The proximity sensor 63 may detect whether the door 30 is in a state of contacting the main body (e.g., the main body 10 of FIG. 1) to close the storage compartment 20. A plurality of proximity sensors 63 may be installed on a plurality of doors 30, respectively. The proximity sensor 63 may transfer an electrical signal for the detected opening/closing state of the door 30 to the controller 100.

In an example, the camera 64 may be installed inside each storage compartment to obtain an internal image of each storage compartment 20. In an example, the camera 64 may be provided outside the refrigerator 1 (e.g., at one position of the outer case 11 of FIG. 1) to obtain an external image around the refrigerator 1. The camera 64 may include image sensors that capture an image and convert the image into an electrical signal. The image sensor may include, e.g., a charge-coupled device (CCD) image sensor or a complementary metal oxide semiconductor (CMOS) image sensor. The electrical signal related to the image captured by the camera 64 may be transferred to the controller 100.

According to an embodiment, the refrigerator 1 may include a cold air supply device 70. In an example, the cold air supply device 70 may include a compressor 71, a condenser 72, an expander 73, and an evaporator 74. Although not shown, the cold air supply device 70 may include a refrigerant pipe connecting the compressor 71, the condenser 72, the expander 73, and the evaporator 74. The refrigerant may circulate between the compressor 71, the condenser 72, the expander 73, and the evaporator 74 through the refrigerant pipe.

The compressor 71 may compress the refrigerant to a high temperature and high pressure state. For example, the compressor 71 may receive electrical energy from the outside and compress the gaseous refrigerant at high temperature and high pressure using a rotational force such as from an electric motor. The compressor 71 is a variable capacity compressor and may vary a capacity by changing a frequency according to a driving control command. The compressed refrigerant may be moved to the condenser 72 by the refrigerant pipe. The condenser 72 may condense the compressed refrigerant received from the compressor 71. The condenser 72 may radiate heat generated while condensing the refrigerant to the outside of the condenser 72. The refrigerant condensed while passing through the condenser 72 may be transferred to the expander 73. The condensed refrigerant may be converted into a low-temperature and low-pressure liquid state while passing through the expander 73. In an example, the expander 73 may be implemented as an electronic expansion valve that may adjust the opening ratio (an electronic expansion valve that may adjust the ratio of the cross-sectional area of the valve's flow path to the cross-sectional area of the valve's flow path while fully open). In such a case, the amount of refrigerant passing through the expander 73 may be controlled depending on the opening ratio of the electronic expansion valve. In an example, the expander 73 may be implemented as a capillary device. The liquid refrigerant may pass through the expander 73 and move to the evaporator 74. The evaporator 74 may exchange heat with surrounding gas while the liquid refrigerant is evaporated. The liquid refrigerant is evaporated by the evaporator 74 to absorb the surrounding latent heat and, if the gas around the evaporator 74 is cooled accordingly, cold air may be generated. The generated cold air may be moved to the storage compartment 20 through a flow path provided between an outer case (e.g., the outer case 12 of FIG. 1) and an inner case (e.g., the inner case 11 of FIG. 1). The refrigerant evaporated in the evaporator 74 may be moved back to the compressor 71 and circulated.

In an example, the cold air supply device 70 may include a thermoelectric element. The thermoelectric element may cool the storage compartment 20 by heating and cooling by the Peltier effect.

In an example, although not specifically shown, the refrigerator 1 may include a machine room in which at least some components of the cold air supply device 70 are disposed. The machine room may be configured to be partitioned and insulated from the storage compartment 20 so as to prevent heat generated from the components disposed in the machine room from being transferred to the storage compartment 20. The inside of the machine room may be configured to communicate with the outside of the main body 10 to dissipate heat from components disposed inside the machine room.

According to an embodiment, the refrigerator 1 may include a display unit 80. In an example, the display unit 80 may be installed on the door 30. In an example, the display unit 80 may display various setting data (e.g., a desired storage compartment temperature) obtained via the input unit 40 and/or the communication unit 50 from the user or the outside or operation control information about the refrigerator 1. In an example, the display unit 80 may display various sensing information (e.g., one or more pieces of temperature information measured by the temperature sensor 61) obtained from the sensor unit 60, the current operating state of the refrigerator 1, and/or various warning/error messages. The display unit 80 may be one of various visual display means capable of displaying images, characters, numbers, or the like, including a liquid crystal display (LCD) panel, a light emitting diode (LED) panel, an organic light emitting diode (OLED) panel, a micro light emitting diode (µLED) panel, a plasma display panel, or the like, but is not limited to a specific type of display unit. In an example, the display unit 80 may include a speaker, and may provide each of the above-described information in the form of a voice via the speaker.

According to an embodiment, the refrigerator 1 may include a lighting unit 90. The lighting unit 90 may be installed in each storage compartment 20 to illuminate the inside of the corresponding storage compartment 20.

In an example, the refrigerator 1 may include a controller 100 for controlling the overall operation of the refrigerator 1. The controller 100 may include a memory 102 for storing a program and/or data for controlling each component of the refrigerator 1, and a processor 101 for generating a control signal for controlling each component of the refrigerator 1 including the cold air supply device 70 or the like according to the program and/or data stored in the memory 102 and information obtained from each of the other components.

In an example, the processor 101 of the controller 100 may receive various input/setting information, e.g., desired storage compartment temperature information, from the input unit 40 and/or the communication unit 50 described above. The processor 101 may obtain sensing information from the sensor unit 60, such as one or more pieces of temperature information detected by the temperature sensor 62, a detection signal detected by the distance sensor 62, door opening/closing information detected by the proximity sensor 63, and/or image information detected by the camera 64. In an example, the controller 100 may obtain information about the state of the inside or outside of the storage compartment 20 of the refrigerator 1 by receiving image information obtained by the camera 64 and analyzing the received image information.

In an example, the processor 101 of the controller 100 may generate an operation control command for each component of the refrigerator 1, based on various information received from the input unit 40, the communication unit 50, and/or the sensor unit 60. In an example, the processor 101 may control the operation of the cold air supply device 70, such as the compressor 71 and/or the expander 73, to adjust the temperature inside the storage compartment 20. In an example, the controller 100 may control the operation of each component of the cold air supply device 70 using information about the temperature of each storage compartment 20 received from the temperature sensor 61. For example, when the temperature inside the storage compartment 20 is higher than a preset temperature, the controller 100 may lower the temperature of the storage compartment 20 by operating the compressor 71 of the cold air supply device 70. In an example, the processor 101 may generate a command for controlling whether or how to display information via the display unit 80. In an example, the processor 101 may generate a command to control to turn on the lighting unit 90 of the opened storage compartment 20 based on information about the opening of the door 30 opening from the proximity sensor 63. For example, the processor 101 may generate a command to control the operation state of each of the above-described input unit 40, communication unit 50, sensor unit 60, and/or lighting unit 90.

In this drawing, the controller 100 is disclosed as being one comprehensive configuration controlling all configurations included in the refrigerator 1, but the present document is not limited thereby. In an example, the refrigerator 1 may be configured to include a plurality of controller configurations individually controlling some of the components of the refrigerator 1. In an example, the refrigerator 1 may include a separate controller including a processor and a memory for controlling the operation of the cold air supply device 70 according to the output of the temperature sensor 61. In an example, the refrigerator 1 may include a separate controller including a processor and a memory for controlling the operation of a user interface according to a user input. The processor 101 of the controller 100 may include a plurality of processors, and the memory 102 may include a plurality of memory devices.

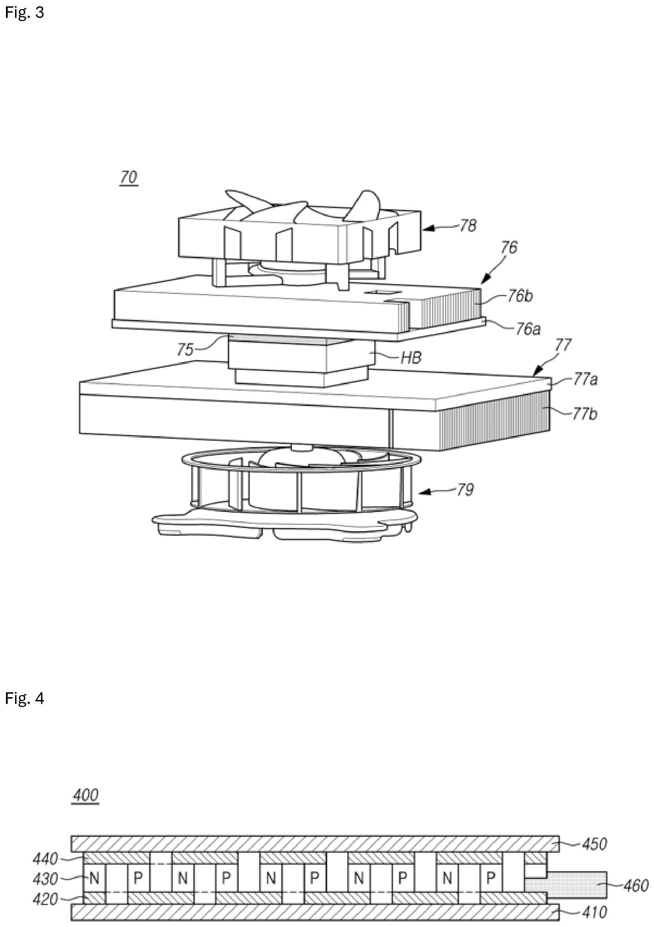

FIG. 3 illustrates a configuration of a cold air supply device 70 according to an embodiment of the disclosure.

Referring to FIG. 3, the cold air supply device 70 may include a thermoelectric module 75, a cooling sink 76, and a heat dissipation sink 77. The thermoelectric module 75 may include a low-temperature portion and a high-temperature portion, and a temperature difference between the low-temperature portion and the high-temperature portion may be determined according to a voltage applied to thermoelectric module 75. The thermoelectric module 75 may be installed such that the low-temperature portion faces upward and the high-temperature portion faces downward.

An outer periphery of the thermoelectric module 75 may be insulated with an insulation member. The thermoelectric module 75 and the insulation member may partition a cooling device chamber into a low-temperature chamber and a high-temperature chamber. Accordingly, the high-temperature portion of the thermoelectric module 75 may not affect the low-temperature portion of the thermoelectric module 75.

The cooling sink 76 may be installed to contact or be adjacent to an exposed surface of the low-temperature portion of the thermoelectric module 75, i.e., a low-temperature surface. Accordingly, the cooling sink 76 may be installed on an upper side of the thermoelectric module 75. In other words, the cooling sink 76 may be installed in the low-temperature chamber of the cooling device chamber.

The cooling sink 76 may include a cooling plate 76a and a cooling fin 76b. The cooling plate 76a may be installed to contact thermoelectric module 75. The cooling plate 76a may contact the low-temperature portion of the thermoelectric module 75 and transfer heat of the low-temperature portion of the thermoelectric module 75 to the cooling fin 76b. The cooling plate 76a may be formed of a material having high thermal conductivity. For example, the cooling plate 76a may be formed in a rectangular shape.

The cooling fin 76b may be installed to contact the cooling plate 76a. The cooling fin 76b may be formed to protrude from one surface of the cooling plate 76a. For example, the cooling fin 76b may be located on an upper portion of the cooling plate 76a. At least a part of the cooling fin 76b may be located in the low-temperature chamber within the cooling device chamber and may cool air via heat exchange with air in the low-temperature chamber. For example, a plurality of cooling fins 76b may be formed to increase a heat exchange area with air. The cooling fin 76b may be formed in a rectangular shape and may be installed on an upper surface of the cooling plate 76a to be spaced apart at regular intervals perpendicular to the upper surface. Accordingly, air introduced into the low-temperature chamber by the cooling fan 78 may flow between the plurality of cooling fins 76b and undergo heat exchange. Air supplied to the cooling sink 76 may be guided by the plurality of cooling fins 76b and introduced into a cooling flow path 13.

The heat dissipation sink 77 may be installed to contact or be adjacent to an exposed surface of the high-temperature portion of the thermoelectric module 75, i.e., a high-temperature surface. Accordingly, the heat dissipation sink 77 may be installed on a lower side of the thermoelectric module 75. For example, the cooling sink 76 may be installed closer to the storage compartment than the heat dissipation sink 77.

The cold air supply device 70 may include a cooling fan 78 circulating air of the storage compartment and a heat dissipation fan 79 circulating external air. The cooling fan 78 may be installed on an upper side of the cooling sink 76 and may circulate air of the storage compartment through the cooling sink 76. For example, the cooling fan 78 may be installed on an upper side of the cooling sink 76 in the low-temperature chamber. Accordingly, air of the storage compartment may be drawn into the low-temperature chamber of the cooling device chamber by the cooling fan 78, pass through the cooling sink 76, and then be discharged back to the storage compartment along the cooling flow path. Accordingly, the cooling fan 78 may circulate air of the storage compartment of the main body 10 to lower the temperature of the storage compartment.

An inlet communicating with the storage compartment may be provided on an upper portion of the cooling fan 78, i.e., on an upper surface of the cooling device chamber. Therefore, when the cooling fan 78 operates, air of the storage compartment may be introduced into the low-temperature chamber of the cooling device chamber through the inlet. The cooling fan 78 may be formed to supply air of the storage compartment to the cooling sink 76. Therefore, when the cooling fan 78 operates, air of the storage compartment may be introduced into the low-temperature chamber and supplied to the plurality of cooling fins 76b of the cooling sink 76. Air introduced by the cooling fan 78 may have a lowered temperature by moving along the plurality of cooling fins 76b and undergoing heat exchange with the plurality of cooling fins 76b. Air introduced by the cooling fan 78 may be introduced into the cooling flow path. Cold air introduced into the cooling flow path may be discharged to the storage compartment of the main body 10 through an outlet.

The heat dissipation sink 77 may be installed to contact or be adjacent to an exposed surface of the high-temperature portion of the thermoelectric module 75, i.e., a high-temperature surface. Accordingly, the heat dissipation sink 77 may be installed on a lower side of the thermoelectric module 75. In other words, the heat dissipation sink 77 may be installed in the high-temperature chamber of the cooling device chamber.

In an embodiment, a heat dissipation block HB may be installed between the heat dissipation sink 77 and the thermoelectric module 75. For example, one end of the heat dissipation block HB may contact the high-temperature surface of the thermoelectric module 75, and another end may be installed to contact the heat dissipation sink 77.

Meanwhile, in another embodiment, the heat dissipation sink 77 may be installed to directly contact the high-temperature surface of the thermoelectric module 75.

The heat dissipation sink 77 may include a heat dissipation plate 77a and a heat dissipation fin 77b. The heat dissipation plate 77a may be installed to contact thermoelectric module 75. The heat dissipation plate 77a may contact the high-temperature portion of the thermoelectric module 75 and transfer heat of the high-temperature portion of the thermoelectric module 75 to the heat dissipation fin 77b. The heat dissipation plate 77a may be formed of a material having high thermal conductivity. For example, the heat dissipation plate 77a may be formed in a rectangular shape.

The heat dissipation fin 77b may be installed to contact the heat dissipation plate 77a. The heat dissipation fin 77b may be formed to protrude from one surface of the heat dissipation plate 77a. The heat dissipation fin 77b may be located on a lower portion of the heat dissipation plate 77a. At least a part of the heat dissipation fin 77b may be located in the high-temperature chamber within the cooling device chamber and may cool the heat dissipation fin 77b via heat exchange with external air introduced into the high-temperature chamber. The plurality of heat dissipation fins 77b may be formed to increase a heat exchange area with external air. The heat dissipation fin 77b may be formed in a rectangular shape and may be installed on a lower surface of the heat dissipation plate 77a to be spaced apart at regular intervals perpendicular to the lower surface. Accordingly, external air introduced by the heat dissipation fan 79 may flow between the plurality of heat dissipation fins 77b and undergo heat exchange with the plurality of heat dissipation fins 77b. External air supplied to the heat dissipation sink 77 may be guided by the plurality of heat dissipation fins 77b and discharged to the outside of the high-temperature chamber.

The heat dissipation fan 79 may be installed on a lower side of the heat dissipation sink 77 and may be formed to circulate air outside the refrigerator 1 through the heat dissipation sink 77. In other words, the heat dissipation fan 79 may be installed on a lower side of the heat dissipation sink 77 in the high-temperature chamber of the cooling device chamber. Accordingly, external air may be drawn into the high-temperature chamber by the heat dissipation fan 79, pass through the heat dissipation sink 77, and then be discharged back to the outside of the refrigerator 1. Accordingly, the heat dissipation fan 79 may draw in external air and lower the temperature of the heat dissipation sink 77. In other words, the heat dissipation fan 79 may lower the temperature of the high-temperature portion of the thermoelectric module 75 using external air.

An inlet and an outlet communicating with the outside may be provided on one side of the heat dissipation fan 79, i.e., on a side surface of the high-temperature chamber of the cooling device chamber. When the heat dissipation fan 79 operates, external air may be introduced into the high-temperature chamber through the inlet, pass through the heat dissipation sink 77, and then be discharged to the outside of the high-temperature chamber through the outlet. Therefore, when the heat dissipation fan 79 operates, the heat dissipation sink 77 in the high-temperature chamber may be cooled by external air.

The heat dissipation fan 79 may be formed to supply external air to the heat dissipation sink 77. Therefore, when the heat dissipation fan 79 operates, external air may be introduced into the high-temperature chamber and supplied to the plurality of heat dissipation fins 77b of the heat dissipation sink 77. External air introduced into the high-temperature chamber by the heat dissipation fan 79 may lower the temperature of the plurality of heat dissipation fins 77b by moving along the plurality of heat dissipation fins 77b and undergoing heat exchange with the plurality of heat dissipation fins 77b. Air heated by heat exchange with the plurality of heat dissipation fins 77b may be discharged to the outside of the high-temperature chamber through the outlet. Accordingly, the heat dissipation fan 79 may dissipate heat of the heat dissipation sink 77, i.e., heat of the high-temperature portion of the thermoelectric module 75, to the outside of the cooling device chamber, i.e., to the outside of the main body 10.

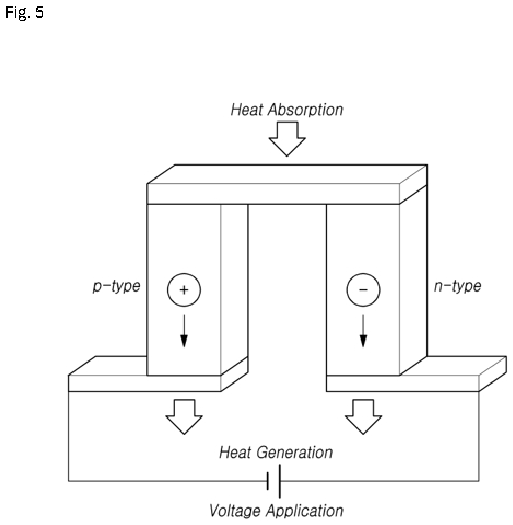

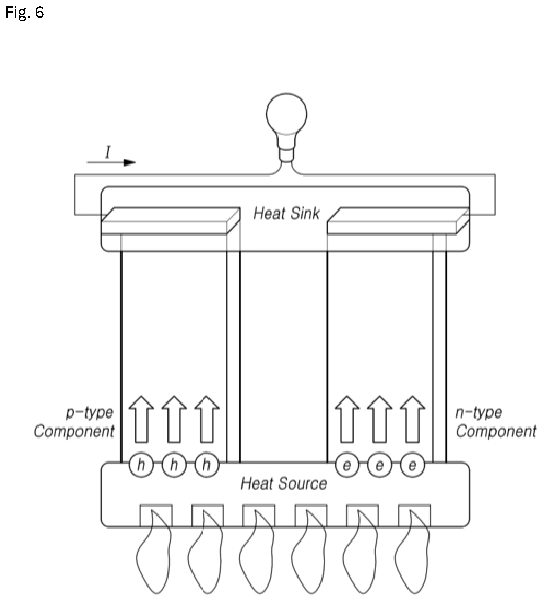

FIG. 4 illustrates a cross-section of a thermoelectric module 400 according to an embodiment of the disclosure, FIG. 5 illustrates thermoelectric cooling by the Peltier effect of the thermoelectric module 400 according to an embodiment of the disclosure, and FIG. 6 illustrates thermoelectric power generation by the Seebeck effect of the thermoelectric module 400 according to an embodiment of the disclosure.

Referring to FIG. 4, the thermoelectric module 400 of the disclosure may include a lower substrate 410, a lower conductive pattern layer 420 formed on the lower substrate 410, a thermoelectric element layer 430 formed on the lower conductive pattern layer 420, an upper conductive pattern layer 440 formed on the thermoelectric element layer 430, an upper substrate 450 formed on the upper conductive pattern layer 440, and at least one surface mount device (SMD) connector 460 electrically connected to the lower conductive pattern layer 420.

The lower substrate 410 may support the lower conductive pattern layer 420 and the thermoelectric element layer 430. The lower substrate 410 may be at least one of a cooling surface and a heat dissipation surface of the thermoelectric module 400. For example, the lower substrate 410 may be a ceramic substrate including at least one of alumina (Al₂O₃), aluminum nitride (AlN), beryllia (BeO), and silicon nitride (Si₃N₄). For example, the lower substrate 410 may be a metal substrate including at least one of aluminum, copper, stainless steel, and nickel. However, the material of the lower substrate 410 of the disclosure is not limited thereto, and for example, the lower substrate 410 may be implemented with various materials including at least one of sapphire, silicon, silicon carbide (SiC), aluminum silicon carbide composite (AlSiC), and quartz.

The lower conductive pattern layer 420 may include at least one lower electrode pattern. The at least one lower electrode pattern may electrically contact at least one thermoelectric element. For example, the at least one lower electrode pattern may electrically contact at least one of an n-type thermoelectric element and a p-type thermoelectric element. The at least one lower electrode pattern may be electrically connected to the at least one SMD connector 460. For example, the at least one lower electrode pattern may include at least one of a positive terminal and a negative terminal electrically connected to the at least one SMD connector 460.

The thermoelectric element layer 430 may include at least one thermoelectric element. For example, the thermoelectric element layer 430 may include at least one of an n-type thermoelectric element and a p-type thermoelectric element. For example, the thermoelectric element layer 430 may include an n-type thermoelectric element and a p-type thermoelectric element alternately arranged.

At least one of the n-type thermoelectric element and the p-type thermoelectric element may include a thermoelectric material. For example, the thermoelectric material may include at least one of bismuth telluride (Bi₂Te₃), lead telluride (PbTe), silicon germanium (SiGe), skutterudite, a metal halide compound, and hafnium hydride (HfH₂).

The upper conductive pattern layer 440 may include at least one upper electrode pattern. The at least one upper electrode pattern may electrically contact at least one thermoelectric element. For example, the at least one upper electrode pattern may electrically contact at least one of an n-type thermoelectric element and a p-type thermoelectric element.

The upper substrate 450 may support the upper conductive pattern layer 440. The upper substrate 450 may be at least one of a cooling surface and a heat dissipation surface of the thermoelectric module 400. For example, the upper substrate 450 may be a ceramic substrate including at least one of alumina (Al₂O₃), aluminum nitride (AlN), beryllia (BeO), and silicon nitride (Si₃N₄). For example, the upper substrate 450 may be a metal substrate including at least one of aluminum, copper, stainless steel, and nickel. However, the material of the upper substrate 450 of the disclosure is not limited thereto, and for example, the upper substrate 450 may be implemented with various materials including at least one of sapphire, silicon, silicon carbide (SiC), aluminum silicon carbide composite (AlSiC), and quartz.

The at least one SMD connector 460 may be electrically connected to the lower conductive pattern layer 420. The at least one SMD connector 460 may include a body portion, an electrode connection portion electrically connected to at least one lower electrode pattern, and a wire connection portion to which at least one wire is fastened.

The at least one SMD connector 460 may supply power to thermoelectric element layer 430 by being electrically connected to the at least one lower electrode pattern. For example, the at least one SMD connector 460 may be connected to at least one positive terminal. The at least one positive terminal may electrically contact an n-type thermoelectric element. For example, the at least one SMD connector 460 may be connected to at least one negative terminal. The at least one negative terminal may electrically contact a p-type thermoelectric element.

In an embodiment, when power of the thermoelectric module 400 is turned on, power may be transmitted to thermoelectric module 400 via the at least one SMD connector 460. For example, when power of the thermoelectric module 400 is turned on, current may flow from the positive terminal to the n-type thermoelectric element. For example, when power of the thermoelectric module 400 is turned on, current may flow from the negative terminal to the p-type thermoelectric element. For example, the at least one SMD connector 460 may be electrically connected to an external power supply source through at least one wire.

For example, as illustrated in FIG. 5, the at least one lower electrode pattern may include at least one of a positive terminal in electrical contact with an n-type thermoelectric element and a negative terminal in electrical contact with a p-type thermoelectric element. The thermoelectric module 400 may receive power from an external power supply source through the positive terminal and the negative terminal. For example, when a DC voltage is applied from the external power supply source to thermoelectric module 400, holes in the p-type thermoelectric element and electrons in the n-type thermoelectric element may move, and heat generation and heat absorption may occur at two opposite ends of the thermoelectric element layer 430.

For example, as illustrated in FIG. 6, at least one of the lower electrode pattern of the lower conductive pattern layer 420 and the upper electrode pattern of the upper conductive pattern layer 440 may be exposed to a heat supply source. When heat is supplied by the external heat supply source, the thermoelectric module 400 may generate power by creating a current flow in the thermoelectric element as electrons and holes move.

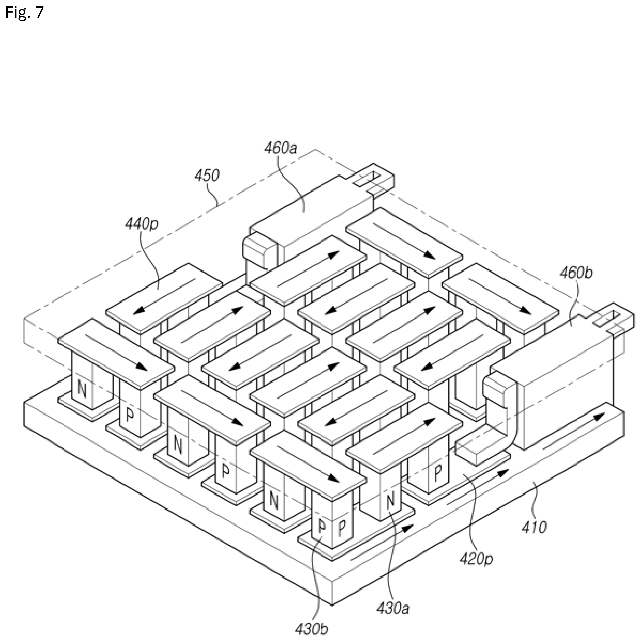

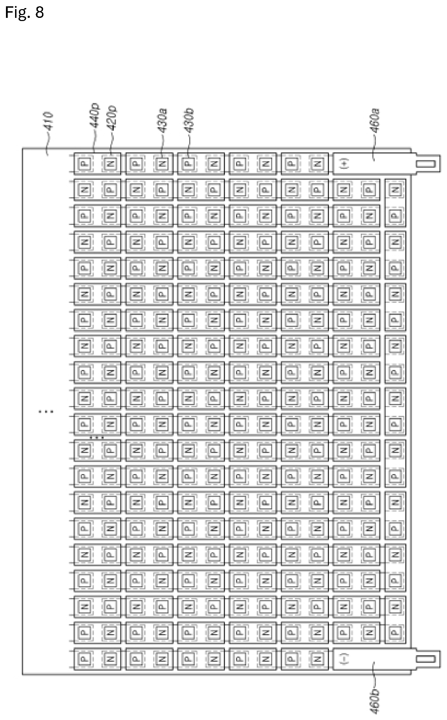

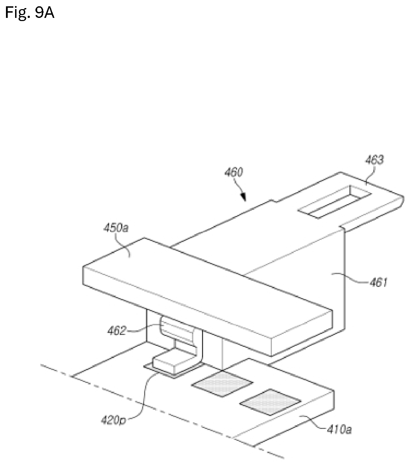

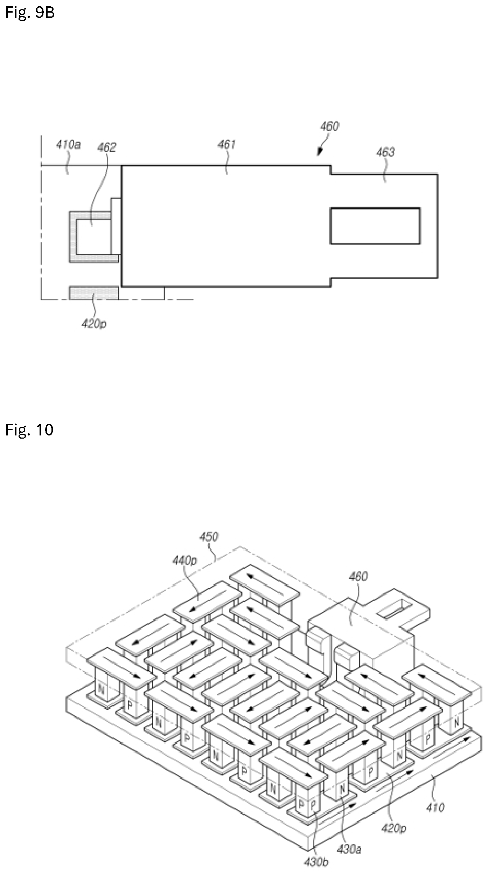

FIG. 7 illustrates a perspective view illustrating the thermoelectric module 400 according to an embodiment of the disclosure, FIG. 8 illustrates a plan view illustrating the thermoelectric module 400 according to an embodiment of the disclosure, FIG. 9A illustrates a perspective view illustrating an SMD connector 460 according to an embodiment of the disclosure, and FIG. 9B illustrates a plan view illustrating the SMD connector 460 according to an embodiment of the disclosure.

Referring to FIGS. 7 to 9B, the thermoelectric module 400 of the disclosure may include a lower substrate 410, a lower conductive pattern layer 420 formed on the lower substrate 410, a thermoelectric element layer 430 formed on the lower conductive pattern layer 420, an upper conductive pattern layer 440 formed on the thermoelectric element layer 430, an upper substrate 450 formed on the upper conductive pattern layer 440, and at least one SMD connector 460 electrically connected to the lower conductive pattern layer 420.

As illustrated in FIG. 7, the thermoelectric element layer 430 may be disposed between the lower conductive pattern layer 420 and the upper conductive pattern layer 440. The thermoelectric element layer 430 may include at least one thermoelectric element. For example, the thermoelectric element layer 430 may include at least one of an n-type thermoelectric element 430a and a p-type thermoelectric element 430b. For example, as illustrated in FIGS. 7 and 8, the thermoelectric element layer 430 may include an n-type thermoelectric element 430a and a p-type thermoelectric element 430b alternately arranged.

The lower conductive pattern layer 420 may include at least one lower electrode pattern 420p. The at least one lower electrode pattern 420p may be electrically connected to at least one thermoelectric element.

The upper conductive pattern layer 440 may include at least one upper electrode pattern 440p. The at least one upper electrode pattern 440p may be electrically connected to at least one thermoelectric element.

The at least one lower electrode pattern 420p may include a positive terminal electrically connected to the at least one SMD connector 460 and a negative terminal electrically connected to the at least one SMD connector 460.

For example, the positive terminal may electrically contact the n-type thermoelectric element 430a. For example, the negative terminal may electrically contact the p-type thermoelectric element 430b.

The at least one SMD connector 460 may be connected to an external power supply source through at least one wire and may transmit current applied from the power supply source to the lower conductive pattern layer 420.

In an embodiment, the at least one SMD connector 460 may be a 1-pin SMD connector 460a, 460b connected to at least one of the positive terminal and the negative terminal. For example, the at least one SMD connector 460 may include a positive 1-pin SMD connector 460a connected to the positive terminal and a negative 1-pin SMD connector 460b connected to the negative terminal.

As illustrated in FIGS. 7 and 8, the positive 1-pin SMD connector 460a and the negative 1-pin SMD connector 460b may be mounted to be spaced apart from each other on the lower conductive pattern layer 420. For example, the positive terminal and the negative terminal may be disposed to be spaced apart from each other on the lower conductive pattern layer 420. For example, the positive 1-pin SMD connector 460a and the negative 1-pin SMD connector 460b may be mounted to be spaced apart from each other on the lower conductive pattern layer 420 by being connected to the positive terminal and the negative terminal, respectively.

Referring to FIGS. 9A and 9B, the at least one SMD connector 460 may include a body portion 461, an electrode connection portion 462 electrically connected to at least one lower electrode pattern 420p, and a wire connection portion 463 to which at least one wire is fastened.

The body portion 461 may be a frame of the at least one SMD connector 460. The body portion 461 may support the electrode connection portion 462 and the wire connection portion 463. An internal hole into which at least one wire may be inserted may be formed inside the body portion 461.

The electrode connection portion 462 may be electrically connected to the at least one lower electrode pattern 420p. For example, the electrode connection portion 462 may include an electrode pin connected to at least one of the positive terminal and the negative terminal.

At least one wire may be fastened to the wire connection portion 463. For example, the wire connection portion 463 may stably transmit current applied from an external power supply source by supporting at least one wire.

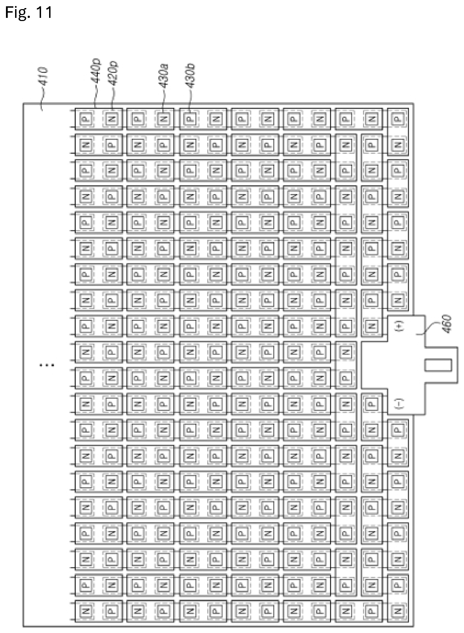

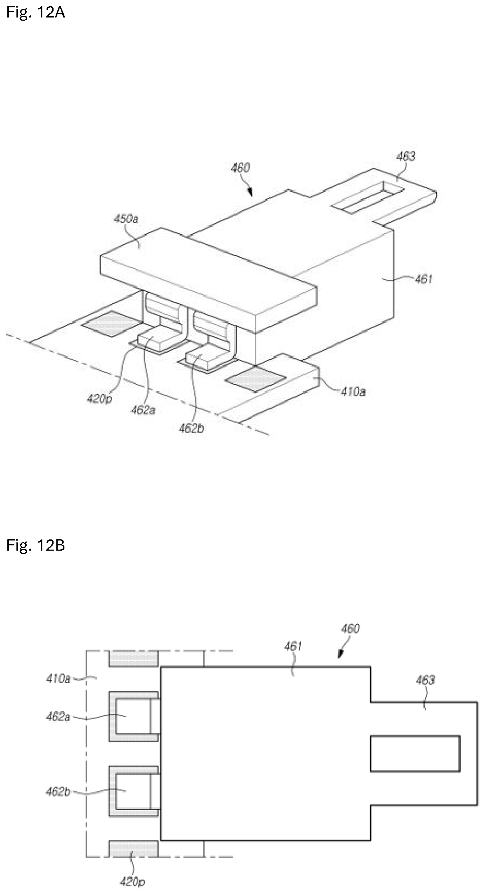

FIG. 10 illustrates a perspective view illustrating the thermoelectric module 400 according to an embodiment of the disclosure, FIG. 11 illustrates a plan view illustrating the thermoelectric module 400 according to an embodiment of the disclosure, FIG. 12A illustrates a perspective view illustrating an SMD connector 460 according to an embodiment of the disclosure, and FIG. 12B illustrates a plan view illustrating the SMD connector 460 according to an embodiment of the disclosure.

Referring to FIGS. 10 to 12B, the thermoelectric module 400 of the disclosure may include a lower substrate 410, a lower conductive pattern layer 420 formed on the lower substrate 410, a thermoelectric element layer 430 formed on the lower conductive pattern layer 420, an upper conductive pattern layer 440 formed on the thermoelectric element layer 430, an upper substrate 450 formed on the upper conductive pattern layer 440, and at least one SMD connector 460 electrically connected to the lower conductive pattern layer 420.

As illustrated in FIG. 10, the thermoelectric element layer 430 may be disposed between the lower conductive pattern layer 420 and the upper conductive pattern layer 440. The thermoelectric element layer 430 may include at least one thermoelectric element. For example, the thermoelectric element layer 430 may include at least one of an n-type thermoelectric element 430a and a p-type thermoelectric element 430b. For example, as illustrated in FIGS. 10 and 11, the thermoelectric element layer 430 may include an n-type thermoelectric element 430a and a p-type thermoelectric element 430b alternately arranged.

The lower conductive pattern layer 420 may include at least one lower electrode pattern 420p. The at least one lower electrode pattern 420p may be electrically connected to at least one thermoelectric element.

The upper conductive pattern layer 440 may include at least one upper electrode pattern 440p. The at least one upper electrode pattern 440p may be electrically connected to at least one thermoelectric element.

The at least one lower electrode pattern 420p may include a positive terminal electrically connected to the at least one SMD connector 460 and a negative terminal electrically connected to the at least one SMD connector 460.

For example, the positive terminal may electrically contact the n-type thermoelectric element 430a. For example, the negative terminal may electrically contact the p-type thermoelectric element 430b.

The at least one SMD connector 460 may be connected to an external power supply source through at least one wire and may transmit current applied from the power supply source to the lower conductive pattern layer 420.

In an embodiment, the at least one SMD connector 460 may be a 2-pin SMD connector 460 respectively connected to at least one of the positive terminal and the negative terminal. For example, the at least one SMD connector 460 may be a 2-pin SMD connector 460 including a first pin connected to the positive terminal and a second pin connected to the negative terminal.

As illustrated in FIGS. 10 and 11, the first pin and the second pin of the 2-pin SMD connector 460 may be mounted adjacent to each other on the lower conductive pattern layer 420. For example, the positive terminal and the negative terminal may be disposed adjacent to each other on the lower conductive pattern layer 420. For example, the first pin and the second pin of the 2-pin SMD connector 460 may be mounted adjacent to each other on the lower conductive pattern layer 420 by being connected to the positive terminal and the negative terminal, respectively.

Referring to FIGS. 12A and 12B, the at least one SMD connector 460 may include a body portion 461, an electrode connection portion 462 electrically connected to at least one lower electrode pattern 420p, and a wire connection portion 463 to which at least one wire is fastened.

The body portion 461 may be a frame of the at least one SMD connector 460. The body portion 461 may support the electrode connection portion 462 and the wire connection portion 463. An internal hole into which at least one wire may be inserted may be formed inside the body portion 461.

The electrode connection portion 462 may be electrically connected to the at least one lower electrode pattern 420p. For example, the electrode connection portion 462 may include a first pin 462a connected to the positive terminal and a second pin 462b connected to the negative terminal.

At least one wire may be fastened to the wire connection portion 463. For example, the wire connection portion 463 may stably transmit current applied from an external power supply source by supporting at least one wire.

Accordingly, the refrigerator including the thermoelectric module 400 of the disclosure does not require performing a separate process of soldering a power supply wire after the manufacturing process of the thermoelectric module 400, and thus the manufacturing process of the thermoelectric module 400 may be simplified and the manufacturing cost may be decreased.

Further, the refrigerator including the thermoelectric module 400 of the disclosure may increase heat transfer efficiency and enhance the performance of the thermoelectric module 400 due to precise electrical connection between the conductive pattern layer and the SMD connector 460 of the thermoelectric module 400.

Further, the refrigerator including the thermoelectric module 400 may lower the disposal rate of the thermoelectric module 400 and increase the lifespan of the thermoelectric module 400 since maintenance, repair, and replacement of the thermoelectric module 400 are facilitated as the SMD connector 460 is mounted on the thermoelectric module 400.

Meanwhile, although FIGS. 1 to 3 illustrate an embodiment in which thermoelectric module 400 of the disclosure is applied to a refrigerator, the refrigerator is merely an example of an electronic device to which thermoelectric module 400 of the disclosure is applied, and does not limit the electronic device to which thermoelectric module 400 of the disclosure is applied. For example, the electronic device to which thermoelectric module 400 of the disclosure is applied may include not only a refrigerator but also various electronic devices to which a thermoelectric element may be applied, such as a dishwasher, an electric range, an electric oven, an air conditioner, a clothing care machine, a washer, a dryer, and a microwave oven.

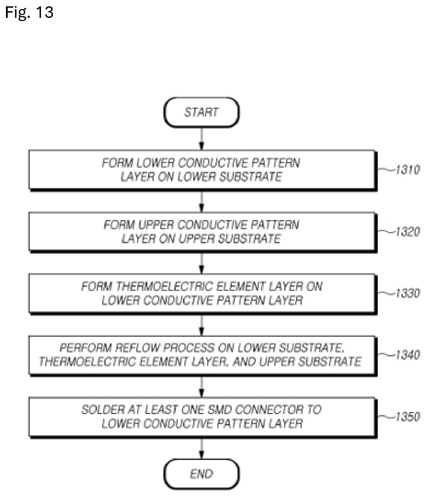

FIG. 13 illustrates a method for manufacturing a thermoelectric module for a refrigerator according to an embodiment of the disclosure.

Referring to FIG. 13, the method for manufacturing a thermoelectric module for a refrigerator according to embodiments of the disclosure may include an operation of forming 1310 a lower conductive pattern layer 420 on a lower substrate 410, an operation of forming 1320 an upper conductive pattern layer 440 on an upper substrate 450, an operation of forming 1330 a thermoelectric element layer 430 on the lower conductive pattern layer 420, an operation of performing 1340 a reflow process on the lower substrate 410, the thermoelectric element layer 430, and the upper substrate 450, and an operation of soldering 1350 at least one SMD connector 460 to the lower conductive pattern layer 420.

According to an example, in operation 1310, the method for manufacturing a thermoelectric module may form the lower conductive pattern layer 420 on the lower substrate 410. For example, the lower substrate 410 may support the lower conductive pattern layer 420 and the thermoelectric element layer 430. The lower substrate 410 may be at least one of a cooling surface and a heat dissipation surface of the thermoelectric module 400. For example, the lower substrate 410 may be a ceramic substrate including at least one of alumina (Al₂O₃), aluminum nitride (AlN), beryllia (BeO), and silicon nitride (Si₃N₄). For example, the lower substrate 410 may be a metal substrate including at least one of aluminum, copper, stainless steel, and nickel. However, the material of the lower substrate 410 of the disclosure is not limited thereto, and for example, the lower substrate 410 may be implemented with various materials including at least one of sapphire, silicon, silicon carbide (SiC), aluminum silicon carbide composite (AlSiC), and quartz.

The lower conductive pattern layer 420 may include at least one lower electrode pattern 420p. The at least one lower electrode pattern 420p may electrically contact at least one thermoelectric element. For example, the at least one lower electrode pattern 420p may electrically contact at least one of an n-type thermoelectric element 430a and a p-type thermoelectric element 430b.

According to an example, in operation 1320, the method for manufacturing a thermoelectric module may form the upper conductive pattern layer 440 on the upper substrate 450. For example, the upper substrate 450 may support the upper conductive pattern layer 440. The upper substrate 450 may be at least one of a cooling surface and a heat dissipation surface of the thermoelectric module 400. For example, the upper substrate 450 may be a ceramic substrate including at least one of alumina (Al₂O₃), aluminum nitride (AlN), beryllia (BeO), and silicon nitride (Si₃N₄). For example, the upper substrate 450 may be a metal substrate including at least one of aluminum, copper, stainless steel, and nickel. However, the material of the upper substrate 450 of the disclosure is not limited thereto, and for example, the upper substrate 450 may be implemented with various materials including at least one of sapphire, silicon, silicon carbide (SiC), aluminum silicon carbide composite (AlSiC), and quartz.

The upper conductive pattern layer 440 may include at least one upper electrode pattern 440p. The at least one upper electrode pattern 440p may electrically contact at least one thermoelectric element. For example, the at least one upper electrode pattern 440p may electrically contact at least one of an n-type thermoelectric element 430a and a p-type thermoelectric element 430b.

According to an example, in operation 1330, the method for manufacturing a thermoelectric module may form thermoelectric element layer 430 on the lower conductive pattern layer 420. For example, the thermoelectric element layer 430 may include at least one thermoelectric element. For example, the thermoelectric element layer 430 may include at least one of an n-type thermoelectric element 430a and a p-type thermoelectric element 430b. For example, the thermoelectric element layer 430 may include an n-type thermoelectric element 430a and a p-type thermoelectric element 430b alternately arranged.

According to an example, in operation 1340, the method for manufacturing a thermoelectric module may perform a reflow process on the lower substrate 410, the thermoelectric element layer 430, and the upper substrate 450. For example, the lower substrate 410, the thermoelectric element layer 430, and the upper substrate 450 may be sequentially stacked in the reflow process and may be fixed by solder paste. For example, in the reflow process, the lower conductive pattern layer 420, the thermoelectric element layer 430, and the upper conductive pattern layer 440 may be electrically connected.

According to an example, in operation 1350, the method for manufacturing a thermoelectric module may solder the at least one SMD connector 460 to the lower conductive pattern layer 420. For example, the at least one SMD connector 460 may be electrically connected to the lower conductive pattern layer 420. The at least one SMD connector 460 may supply power to thermoelectric element layer 430 by being electrically connected to the at least one lower electrode pattern 420p. For example, the at least one SMD connector 460 may be connected to at least one positive terminal. The at least one positive terminal may electrically contact the n-type thermoelectric element 430a. For example, the at least one SMD connector 460 may be connected to at least one negative terminal. The at least one negative terminal may electrically contact the p-type thermoelectric element 430b.

As described above, the method for manufacturing a thermoelectric module 400 for a refrigerator of the disclosure may manufacture thermoelectric module 400 having an SMD connector 460 mounted thereon and receiving power from an external source through a wire.

Accordingly, the method for manufacturing a thermoelectric module 400 for a refrigerator of the disclosure does not require performing a separate process of soldering a power supply wire after the manufacturing process of the thermoelectric module 400, and thus the manufacturing process of the thermoelectric module 400 may be simplified and the manufacturing cost may be decreased.

Further, the method for manufacturing a thermoelectric module 400 for a refrigerator of the disclosure may increase heat transfer efficiency and enhance the performance of the thermoelectric module 400 due to precise electrical connection between the conductive pattern layer and the SMD connector 460 of the thermoelectric module 400.

Further, the method for manufacturing a thermoelectric module 400 for a refrigerator may lower the disposal rate of the thermoelectric module 400 and increase the lifespan of the thermoelectric module 400 since maintenance, repair, and replacement of the thermoelectric module 400 are facilitated as the SMD connector 460 is mounted on the thermoelectric module 400.

However, since this has been described above, redundant descriptions thereof are omitted.

A refrigerator 1 according to embodiments of the disclosure may include a storage compartment 20, a main body 10 including the storage compartment 20, and a cold air supply device 70 supplying cold air to the storage compartment 20. The cold air supply device 70 may include a thermoelectric module 400. The thermoelectric module 400 may include a lower substrate 410, a lower conductive pattern layer 420 formed on the lower substrate 410, a thermoelectric element layer 430 formed on the lower conductive pattern layer 420, an upper conductive pattern layer 440 formed on the thermoelectric element layer 430, an upper substrate 450 formed on the upper conductive pattern layer 440, and at least one SMD connector 460 electrically connected to the lower conductive pattern layer 420.

In an embodiment, the lower conductive pattern layer 420 may include at least one lower electrode pattern 420p. The at least one lower electrode pattern 420p may include a positive terminal electrically connected to the at least one SMD connector 460 and a negative terminal electrically connected to the at least one SMD connector 460.

In an embodiment, the thermoelectric element layer 430 may include an n-type thermoelectric element 430a and a p-type thermoelectric element 430b alternately arranged.

In an embodiment, the positive terminal may electrically contact the n-type thermoelectric element 430a. The negative terminal may electrically contact the p-type thermoelectric element 430b.

In an embodiment, the at least one SMD connector 460 may be connected to an external power supply source through at least one wire and may transmit current applied from the power supply source to the lower conductive pattern layer 420.

In an embodiment, the at least one SMD connector 460 may include a body portion 461, an electrode connection portion 462 electrically connected to at least one lower electrode pattern 420p, and a wire connection portion 463 to which at least one wire is fastened.

In an embodiment, the at least one SMD connector 460 may be a 1-pin SMD connector connected to at least one of the positive terminal and the negative terminal.

In an embodiment, the positive terminal and the negative terminal may be disposed to be spaced apart from each other on the lower conductive pattern layer 420.

In an embodiment, the at least one SMD connector 460 may be a 2-pin SMD connector respectively connected to at least one of the positive terminal and the negative terminal.

In an embodiment, the positive terminal and the negative terminal may be disposed adjacent to each other on the lower conductive pattern layer 420.

A method for manufacturing a thermoelectric module for a refrigerator according to embodiments of the disclosure may include an operation of forming a lower conductive pattern layer 420 on a lower substrate 410, an operation of forming an upper conductive pattern layer 440 on an upper substrate 450, an operation of forming a thermoelectric element layer 430 on the lower conductive pattern layer 420, an operation of performing a reflow process on the lower substrate 410, the thermoelectric element layer 430, and the upper substrate 450, and an operation of soldering at least one SMD connector 460 to the lower conductive pattern layer 420.

In an embodiment, the operation of forming a lower conductive pattern layer 420 on the lower substrate 410 may include an operation of forming a lower conductive pattern layer 420 including at least one lower electrode pattern 420p on the lower substrate 410. The operation of forming the lower conductive pattern layer 420 may include an operation of forming a positive terminal electrically connected to the at least one SMD connector 460 and an operation of forming a negative terminal electrically connected to the at least one SMD connector 460.

In an embodiment, the operation of forming a thermoelectric element layer 430 on the lower conductive pattern layer 420 may include an operation of forming an n-type thermoelectric element 430a and a p-type thermoelectric element 430b alternately arranged on the lower conductive pattern layer 420.

In an embodiment, the positive terminal may electrically contact the n-type thermoelectric element 430a. The negative terminal may electrically contact the p-type thermoelectric element 430b.

In an embodiment, the at least one SMD connector 460 may be connected to an external power supply source through at least one wire and may transmit current applied from the power supply source to the lower conductive pattern layer 420.

In an embodiment, the at least one SMD connector 460 may include a body portion 461, an electrode connection portion 462 electrically connected to at least one lower electrode pattern 420p, and a wire connection portion 463 to which at least one wire is fastened.

In an embodiment, the at least one SMD connector 460 may be a 1-pin SMD connector connected to at least one of the positive terminal and the negative terminal.

In an embodiment, the positive terminal and the negative terminal may be disposed to be spaced apart from each other on the lower conductive pattern layer 420.

In an embodiment, the at least one SMD connector 460 may be a 2-pin SMD connector respectively connected to at least one of the positive terminal and the negative terminal.

In an embodiment, the positive terminal and the negative terminal may be disposed adjacent to each other on the lower conductive pattern layer 420.

## Claims

1. A refrigerator (1) comprising:
a storage compartment (20);
a main body (10) including the storage compartment; and
a cold air supply device (70) supplying cold air to the storage compartment,
wherein the cold air supply device includes a thermoelectric module (75), and
wherein the thermoelectric module (75) includes:
a lower substrate (410);
a lower conductive pattern layer (420) formed on the lower substrate (410);
a thermoelectric element layer (430) formed on the lower conductive pattern layer (420);
an upper conductive pattern layer (440) formed on the thermoelectric element layer (430);
an upper substrate (450) formed on the upper conductive pattern layer (440); and
at least one surface mount device (SMD) connector (460) electrically connected to the lower conductive pattern layer (420).

2. The refrigerator of claim 1,
wherein the lower conductive pattern layer (420) includes at least one lower electrode pattern (420p), and
wherein the at least one lower electrode pattern (420p) includes:
a positive terminal electrically connected to the at least one SMD connector (460);
and
a negative terminal electrically connected to the at least one SMD connector (460).

3. The refrigerator of claim 2, wherein the thermoelectric element layer (430) includes an n-type thermoelectric element (430a) and a p-type thermoelectric element (430b) alternately arranged.

4. The refrigerator of claim 2, wherein the positive terminal is in electrical contact with an n-type thermoelectric element (430a), and the negative terminal is in electrical contact with a p-type thermoelectric element (430b).

5. The refrigerator of any one of claims 2 to 4, wherein the at least one SMD connector (460) is connected to an external power supply source through at least one wire and transmits current applied from the power supply source to the lower conductive pattern layer (420).

6. The refrigerator of any one of claims 2 to 4, wherein the at least one SMD connector (460) includes:
a body portion (461);
an electrode connection portion (462) electrically connected to at least one lower electrode pattern; and
a wire connection portion (463) to which at least one wire is fastened.

7. The refrigerator of any one of claims 2 to 6, wherein the at least one SMD connector (460) is a 1-pin SMD connector connected to at least one of the positive terminal and the negative terminal.

8. The refrigerator of claim 7, wherein the positive terminal and the negative terminal are disposed to be spaced apart from each other on the lower conductive pattern layer (420).

9. The refrigerator of any one of claims 2 to 6, wherein the at least one SMD connector (460) is a 2-pin SMD connector respectively connected to at least one of the positive terminal and the negative terminal.

10. The refrigerator of claim 9, wherein the positive terminal and the negative terminal are disposed adjacent to each other on the lower conductive pattern layer (420).
